# FASCICULE DE BREVET EUROPEEN

(11) **EP 2 434 031 B1**
(45) Date de publication et mention de la délivrance du brevet: **15.05.2013**
(21) Numéro de dépôt: 10193388.5
(22) Date de dépôt: 01.12.2010
(51) Int. Cl.: C23C 14/00, C23C 14/02, C23C 14/34, C23C 14/14, G04B 19/12, G02B 5/02, G04D 3/00

(54) **Revêtement décoratif blanc, article décoratif et procédé**
Weiße Zierverkleidung, Dekoartikel und Verfahren
White decorative covering, decorative item and method

(30) Priorité: 28.09.2010 CH 15782010
(43) Date de publication de la demande: 28.03.2012
(73) Titulaire: Haute Ecole Arc, 2610 St.-Imier (CH)
(72) Inventeur: Jeanneret, Patrick, 2052, Fontainemelon (CH)
(74) Mandataire: P&TS SA (AG, Ltd.)

(56) Documents cités:
- GB-A- 1 460 784
- US-A- 4 583 866
- US-A- 5 282 902
- US-A- 5 985 469
- US-A1- 2009 176 121

## Description

### Domaine technique

La présente invention se rapporte à un revêtement décoratif présentant la surface de couleur blanche obtenu par un dépôt physique sous vide en phase vapeur (PVD) tel que la pulvérisation cathodique. Des modes de réalisations de l'invention concernent des articles décoratifs avec une surface blanche pour la production des éléments de montres, de bijoux, de lunettes ou autres objets de décoration, ainsi qu'un procédé pour la fabrication de telle surface.

### Etat de la technique

L'industrie du domaine décoratif, par exemple l'horlogerie, est à la recherche de nouvelles solutions en termes de couleurs et l'apparence. Les articles horlogers de couleur blanche, tels que les cadrans, sont souvent obtenus par l'application de nacres et de l'émail.

La surface des métaux tels que argent, platine, palladium, rhodium offre une apparence blanche éclatante. Il est aussi possible d'obtenir une telle apparence par le dépôt galvanique (électrolytique) de ces métaux. Cependant ils réfléchissent la lumière de manière spéculaire, ce qui confère à la surface un éclat brillant métallique. Le paramétrage judicieux du procédé de dépôt galvanique permet une diminution de l'éclat de ce revêtement qui devient blanc mat.

Les techniques de dépôt physique sous vide en phase vapeur (PVD), par exemple la pulvérisation cathodique, permettent d'obtenir les revêtements minces avec des propriétés prédéfinies sur des substrats de nature différente et ayant une géométrie complexe (tridimensionnelle).

Plusieurs substances naturelles possèdent une couleur blanche. A titre d'exemple, citons des pigments constitués de microparticules de substances minérales telles que d'oxyde de titane ou d'aluminium. Ces particules, qui font partie d'une nacre ou d'un email, réfléchissent la lumière de manière diffuse. La taille de particules est responsable de l'aspect blanc de la surface.

La couleur blanche provient de la capacité d'une surface de réfléchir la lumière blanche de manière diffuse. Pour diffuser efficacement la lumière, la surface doit être rugueuse, avec la taille des aspérités comparable aux longueurs d'onde du spectre visible (quelques dizaines ou centaines de nanomètres).

Les diffuseurs de lumière sont bien connus dans la photographie, dans les cellules photovoltaïques et pour le retro-éclairage des écrans. Les diffuseurs sont composés soit des surfaces revêtues des films contenant des microparticules de pigments, telles que dioxyde de titane, oxyde de zinc ou oxyde de cérium (demande de brevet WO 2007081484), soit des surfaces microstructurées. Le document EP1363143 cite une surface ayant des structures de taille entre 50 et 450 nanomètres de l'hauteur. Ces structures étant fabriquées par un procédé « hot-embossing ». La surface est ensuite revêtue d'une couche d'un polymère conjugué.

US5985469 décrit un article décoratif blanc comprenant un substrat et une couche blanche réalisée par un nitrure, un carbure, un carbonitrure d'un élément parmi Ti, Hf, Zr, Ta, V, Cr, Al. US2009176121 divulgue un film diffuseur poreux déposé par pulvérisation cathodique en présence d'hydrogène pour des réflecteurs pour des lampes, US5282902 décrit une celle solaire avec un substrat conducteur rugueux, et GB1460784 un cadran de montre avec une couche réfléchissante, une couche transparente et une couche semi-transparente.

Dans la présente invention, les coordonnées colorimétriques de la surface inventive sont exprimées à l'aide de l'espace colorimétrique CIEL*a*b* mesurées selon standard CIE1976 (mode SCI, illuminant D65-10°).

### Bref résumé de l'invention

Un but de la présente invention est de proposer un procédé de fabrication d'un revêtement blanc mat ou légèrement brillant.

Les techniques de dépôt physique sous vide en phase vapeur, par exemple la pulvérisation cathodique, permettent d'obtenir les revêtements minces sur des substrats de nature différente sur une géométrie complexe (tridimensionnelle) avec une couleur blanche mat proche de l'apparence obtenue par le dépôt galvanique ou par l'application des nacres et des émaux. Ce dépôt est à base d'argent cependant il ne présente pas l'éclat métallique de l'argent.

Cette solution présente notamment l'avantage par rapport à l'art antérieur de permettre l'obtention de couleur blanche mate sur une grande variété des substrats (conducteurs et non-conducteurs, bi- et tridimensionnels).

La couleur blanche est obtenue grâce à la topographie de surface du revêtement. En choisissant judicieusement des conditions du procédé, il est possible d'obtenir une surface structurée réfléchissant efficacement la lumière blanche de manière diffuse. La couleur blanche est comparable de celle du papier mat ou, selon l'état du substrat, peut être plus ou moins brillant, sans toutefois l'apparence métallique ou spéculaire de l'argent poli.

### Brève description des figures

Des exemples de mise en oeuvre de l'invention sont indiqués dans la description illustrée par les figures annexées dans lesquelles :
La figure 1 illustre une enceinte de pulvérisation utilisable dans le cadre de l'invention.
La figure 2 illustre schématiquement le déroulement d'un procédé de déposition selon un aspect de l'invention.
La figure3 illustre schématiquement, non à l'échelle et en coupe la structure de revêtement décoratif d'un article décoratif selon l'invention.
La figure 4 montre une photographie de surface décorative selon l'invention réalisée par la microscopie électronique à balayage.

### Exemple(s) de mode de réalisation de l'invention

Selon un aspect de l'invention, la déposition des revêtements conférant une couleur blanche mat ou brillant à la surface de l'article décoratif est effectuée par un procédé PVD, notamment la pulvérisation cathodique magnétron.

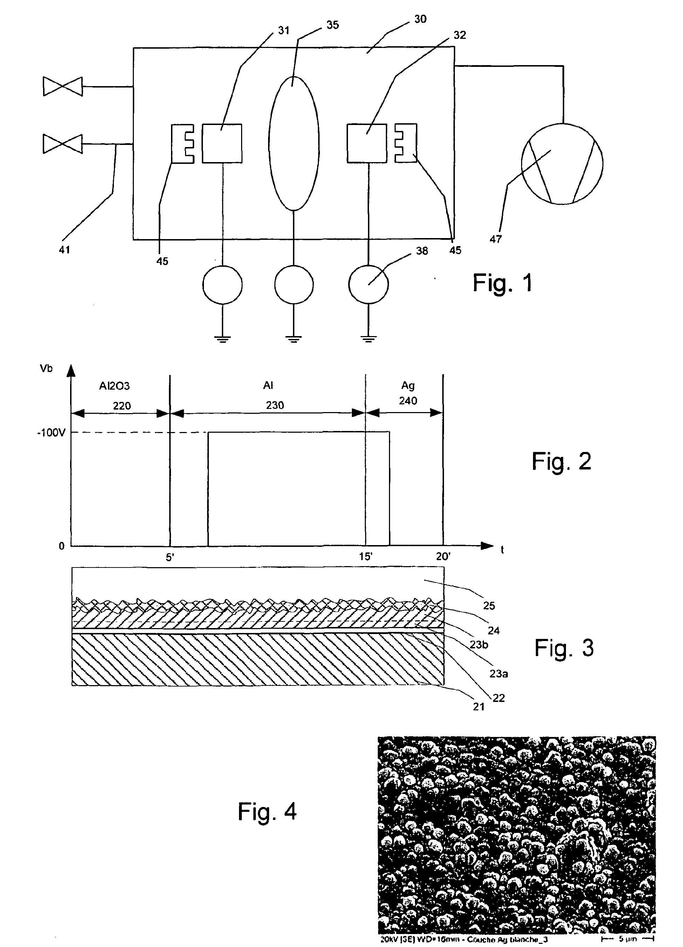

La figure 1 représente, de manière très simplifiée, une enceinte de pulvérisation 30 de type magnétron pouvant être utilisée dans le cadre de l'invention, et comprenant un arrangement d'aimants 45, des canaux de refroidissement, deux cibles de pulvérisation 31 et 32, par exemple une cible 31 d'aluminium et une cible 32 d'argent métallique, et des sources de tension 38 pouvant porter les cibles 31 et 32, ainsi que le porte-substrat 35 a potentiel électrique voulu. Les sources peuvent être des sources DC, RF ou pulsées, selon les cas. Le système de pulvérisation inclut également une installation à vide 47 et des lignes de remplissage 41 permettant de réaliser, à l'intérieur de l'enceinte, une atmosphère contrôlée de type réactif ou inerte. Le fonctionnement de ce dispositif de pulvérisation est décrit dans la littérature scientifique et technique, et il ne sera répété ici que dans les grandes lignes.

La pulvérisation cathodique magnétron consiste à pulvériser une cible constituée d'un matériau à déposer en film mince. La cible, par exemple l'une des cibles 31 et 32, est chargée négativement, le reste de l'enceinte y compris le porte-substrat est à la terre. Après avoir créé du vide dans l'enceinte, le gaz inerte, tel que argon, y sera introduit à faible pression. En appliquant la différence de potentiels entre la cible et l'enceinte, les atomes du gaz seront ionisés, le plasma sera créé à l'intérieur de l'enceinte. La présence des aimants derrière la cible confine le plasma proche de cette dernière.

Les ions de gaz se dirigent vers la cible et bombardent celle-ci. Ceci provoque la pulvérisation des atomes de la cible qui se condensent sur les parois intérieurs de l'enceinte, y compris sur le substrat. La pulvérisation s'effectuant en mode non-réactif (dans une atmosphère d'argon pur) résulte en un dépôt du matériau de la cible.

Selon un mode de réalisation, que sera maintenant décrit avec référence aux figures 2 et 3, la surface de couleur blanche est composée d'un revêtement comprenant au moins deux couches 23, 24 sur un substrat 21.
Préférablement, le procédé de l'invention comporte une étape 220 de déposition d'une sous-couche 22 sur le substrat 21. La sous-couche peut être par exemple composée de Al203.fabriquée par pulvérisation d'une source de Al en une atmosphère réactive contenant 02. La tension électrique V_{b} du substrat 21 est proche de zéro. La durée de cette étape peut être, par exemple de 5', comme indiquée par la figure 2, mais cela n'est pas une caractéristique essentielle de l'invention, la durée pouvant être supérieure ou inférieure selon l'épaisseur désirée, la puissance de la source et la géométrie de déposition.

L'étape 230 comporte la fabrication d'une couche rugueuse 23, par exemple, une première en aluminium métallique pur et sert à créer une surface rugueuse. Elle se fait préférablement en deux étapes. D'abord, une première sous-couche 23a en Aluminium est déposée en conditions "normales" soit, par exemple, polarisant la cible d'aluminium négativement et laissant le porte-substrat 35 à la terre, ou à un potentiel proche de zéro, et en atmosphère inerte de gaz Ar. Le but de cette déposition est d'obtenir une couche d'aluminium qui servira de base pour la suite de la déposition. Ensuite, la déposition d'aluminium se poursuit avec l'application d'un bias négatif sur le porte-substrat 35, par exemple de -100V. De cette façon on génère une sous-couche 23b ayant une rugosité optimale nécessaire pour la création d'une surface structurée.

Sans vouloir être limités par l'interprétation théorique, on croit que l'effet de la polarisation négative du porte-substrat 35 provoque une formation de plasma en proximité de celui-ci, en sorte que la sous-couche 23b est la cible d'un vigoureux bombardement ionique et est, au moins en partie, repulverisée lors de la déposition. La rugosité de la couche 23b est invisible à l'oeil nu et imperceptible au toucher, la taille moyenne des aspérités est préférablement inférieure à 10 µm, plus préférablement inférieure à 2 µm. On a constaté que ces résultats peuvent être obtenus par des dépositions d'une durée comprise entre 1' et 5' avec une tension de -100V au porte-substrat 35.

La distinction entre les deux sous-couches 23a, 23b est relative uniquement aux conditions de pulvérisation, qui diffèrent par l'application d'une tension électrique négative lors de la déposition de la sous-couche 23b. Les deux couches dans cet exemple ont en fait la même composition chimique et ne son pas nécessairement distinguables dans l'article de l'invention. Par ailleurs, la première couche 23a pourrait être omise, ou bien ou pourrait envisager une transition graduelle de la tension du porte-substrat 35, sans discontinuités entre les deux sous-couches.

Finalement, dans l'étape 240 la deuxième cible 32 est activée, tandis que la cible 31 est désactivée, et que le porte-substrat 35 est ramené à un potentiel électrique nul ou proche de zéro. La cible 32 est préférablement une cible d'argent pur, ou d'un autre matériau hautement réfléchissant. Une couche réfléchissante 24 est alors déposée sur la couche rugueuse 23. La couche réfléchissante suit le profil de la couche sous-jacente 23b et présente une rugosité comparable à celle de la couche rugueuse 23b. La surface extérieure de la couche réfléchissante 24 réfléchit efficacement la lumière blanche de manière diffuse et non spéculaire.

Dans une variante de l'invention, le substrat 21 présente une surface structurée ou décorée, par exemple un élément d'horlogerie avec une surface gravée, perlée, satinée, à côtes de Genève, guillochée, etc. Le revêtement décoratif de l'invention est suffisamment mince pour permettre de voir la décoration du substrat sous-jacent. On obtient alors une surface blanche décorée. Préférablement, la couche réfléchissante et la couche rugueuse présentent une épaisseur inférieure à 10 µm, préférablement inférieure à 4 µm, plus préférablement comprise entre 1 et 3 µm.

On obtient de cette façon des surfaces de couleur blanche dont les coordonnées colorimétriques L*, a*, b* sont suivantes : a* variant de -3 à +3, b* variant de -3 à +3 et L* variant de +94 à +100.

Le procédé de l'invention se prête à plusieurs variantes. On pourrait par exemple déposer une sous-couche colorée pour obtenir des surfaces ayant une nuance de couleur. On a observé qu'une sous-couche 22 non métallique, par exemple de Al2O3, améliore la rugosité et l'uniformité de la couche rugueuse. Selon une autre variante du procédé, cette sous-couche pourrait être de nature métallique, ceci est pour but d'améliorer l'adhérence du revêtement au substrat. Par exemple on pourrait déposer les couches 23, 24 sur une sous-couche 22 présentant une des compositions suivantes : Cr, Ti, Al2O3, AIN, AlON, SiO2, TiO2, ZrO2, DLC (diamond-like carbon).

On pourrait également remplacer l'aluminium et argent par des autres matériaux, par exemple on pourrait déposer des couches 24 d'or, de cuivre, de palladium, de rhodium ou de tout autre matériau pour réaliser des surfaces mat ayant une teinte. On pourrait déposer également des couches 24 d'alliages contenant argent, par exemple Ag-Pd, Ag-Al, Ag-Rh.

L'invention pourrait aussi prévoir la déposition de couches supplémentaires, par exemple des couches de protection contre le ternissement ou/et des couches transparentes anti-usure 25. La couche de protection pourrait par exemple présenter une des compositions inorganiques suivantes: Al2O3, AIN, AION, ZnO, SiO2, TiO2, ZrO2, DLC (diamond-like carbon) et leur combinaisons.

Par ailleurs, la couche de protection 25 pourrait aussi être une couche organique peinte, pulvérisée ou appliquée par n'importe quel procédé approprié. Par exemple elle pourrait être une couche de laque, laque acrylique, vernis à la nitrocellulose (zapon), une couche polymère etc. Lorsque la couche réfléchissante est réalisée en argent, on pourra appliquer les procédés connus et normalement employés pour éviter le ternissement de ce métal, par exemple des procédés anti-ternissement chimiques, galvaniques ou physiques.

Le procédé inventif pourrait aussi inclure des étapes de nettoyage des substrats avant le dépôt par décapage ionique.

Le procédé de l'invention permet de déposer un revêtement de couleur blanche sur divers articles afin d'obtenir des articles décoratifs particulièrement attrayants. On peut par exemple déposer un revêtement blanc mat ou brillant par le procédé inventif sur des éléments de montre, notamment des composants d'habillage interne tels que cadrans, aiguilles, index, ponts, platines, barillets. Par ailleurs, le procédé de l'invention peut être appliqué également à d'autres articles décoratifs, par exemple des bijoux ou des carrures des lunettes.

## Revendications

1. Procédé de déposition d'un revêtement de couleur sur un article décoratif comprenant des étapes de :
- déposition par un procédé de dépôt physique en phase vapeur d'une couche rugueuse (23ab) sur un substrat (21);
- déposition par un procédé de dépôt physique en phase vapeur d'une couche réfléchissante (24) sur ladite couche rugueuse, dans lequel la couche réfléchissante (24) suit le profil de la couche rugueuse (23ab),
**caractérisé en ce que** la dite couche rugueuse est (23b) est déposée par pulvérisation cathodique avec l'application d'une tension électrique négative au substrat (21).

2. Procédé de déposition d'un revêtement selon la revendication précédente, comprenant en outre des étapes de déposer une sous-couche (22) entre le substrat (21) et la couche rugueuse (23) et/ou une couche de protection (25) au dessus de la couche réfléchissante (24)

3. Procédé de déposition d'un revêtement selon l'une des revendications, précédentes, dans lequel au moins une parmi lesdites couches sont déposées par un procédé de pulvérisation cathodique.

4. Procédé de déposition d'un revêtement selon l'une des revendications, précédentes, dans lequel la couche rugueuse est une couche d'aluminium, et la couche réfléchissante est une couche d'argent.

5. Procédé de déposition d'un revêtement selon l'une des revendications, précédentes, dans lequel la couche rugueuse (23) et la couche réfléchissante (24) ont une épaisseur inférieure à 10 µm, préférablement inférieure à 4 µm, plus préférablement comprise entre 1 et 3 µm.

6. Procédé de déposition d'un revêtement selon l'une des revendications, précédentes, dans lequel la couche rugueuse (23) présente des aspérités d'une taille moyenne inférieure à 10 µm, préférablement inférieure à 2 µm.

7. Procédé selon l'une des revendications précédentes, dans lequel ledit revêtement présente une couleur blanche mat ou brillant, mesurée selon le standard CIE 1976, avec une valeur de paramètre a* variant de -3 à 3, b* variant de -3 à 3 et L* variant de 94 à 100.

8. Procédé selon l'une des revendications précédentes dans lequel le substrat (21) présente une décoration.

## Patentansprüche

1. Verfahren zum Auftragen einer farbigen Beschichtung auf einem dekorativen Artikel, aufweisend die Schritte:
- Auftragen einer groben Schicht (23ab) auf einem Substrat (21) durch eine physikalische Gasphasenabscheidung;
- Auftragen einer reflektierenden Schicht (24) über die grobe Schicht durch eine physikalische Dampfphasenabscheidung, wobei die reflektierende Schicht (24) dem Profil der groben Schicht (23ab) folgt,
**dadurch gekennzeichnet, dass** die grobe Schicht (23b) durch Kathodenzerstäuben mit dem Anlegen eines negativen Bias zu dem Substrat (21) aufgetragen wird.

2. Verfahren zum Auftragen einer Beschichtung nach dem vorigen Anspruch, weiter aufweisend einen Schritt des Auftragens einer Unterschicht (22) zwischen dem Substrat (21) und der groben Schicht (23) und / oder einer schützenden Schicht (25) über der reflektierenden Schicht (24).

3. Verfahren zum Auftragen einer Beschichtung nach einem der vorigen Ansprüche, wobei mindestens eine der Schichten durch ein Verfahren des Kathodenzerstäubens aufgetragen wird.

4. Verfahren zum Auftragen einer Beschichtung nach einem der vorigen Ansprüche, wobei die grobe Schicht eine Aluminium Schicht ist, und die reflektierende Schicht eine Silberschicht ist.

5. Verfahren zum Auftragen einer Beschichtung nach einem der vorigen Ansprüche, wobei die grobe Schicht (23) und die reflektierende Schicht (24) eine Dicke von weniger als 10 µm, vorzugsweise weniger als 4 µm, noch bevorzugter zwischen 1 und 3 µm aufweist.

6. Verfahren zum Auftragen einer Beschichtung nach einem der vorigen Ansprüche, wobei die grobe Schicht (23) Oberflächenunebenheiten von einer mittleren Grösse von weniger als 10 µm, bevorzugterweise weniger als 2 µm aufweist.

7. Verfahren zum Auftragen einer Beschichtung nach einem der vorigen Ansprüche, wobei die Beschichtung eine matte oder glänzende weisse Farbe, gemessen nach CIE 1976, mit einem A* Parameter zwischen -3 und 3 und einem B* Parameter zwischen -3 und 3 und dem L* Parameter zwischen 94 und 100.

8. Verfahren zum Auftragen einer Beschichtung nach einem der vorigen Ansprüche, wobei das Substrat (21) eine Dekoration darstellt.

## Claims

1. Method of depositing a coloured coating on a decorative article comprising the steps of:
- depositing by a method of physical vapour phase deposition a rough layer (23ab) on a substrate (21);
- depositing by a method of physical vapour phase deposition a reflective layer (24) over said rough layer, wherein the reflective layer (24) follows the profile of the rough layer (23ab),
**Characterised in that** the rough layer (23b) is deposed by cathode sputtering with the application of a negative bias to the substrate (21).

2. Method of depositing a coating according to the preceding claim, further comprising a step of depositing an under-layer (22) between the substrate (21) and the rough layer (23) and/or a protective layer (25) over the reflective layer (24)

3. Method of depositing a coating according to one of the preceding claims, wherein at least one of the layers is deposited by a method of cathode sputtering.

4. Method of depositing a coating according to one of the preceding claims, wherein the rough layer is an aluminium layer, and the reflective layer is a silver layer.

5. Method of depositing a coating according to one of the preceding claims, wherein the rough layer (23) and the reflective layer(24) have a thickness lower than 10 µm, preferably lower than 4 µm, more preferably comprised between1 et 3 µm.

6. Method of depositing a coating according to one of the preceding claims, wherein the rough layer (23) has asperities of an average size lower than 10 µm, preferably lower than 2 µm.

7. Method according to one of the preceding claims, wherein said coating presents a mat or brilliant white colour, measured according to the CIE 1976, with the a* parameter varying between -3 and 3, the b* parameter varying between -3 and 3, and the L* parameter varying between 94 and 100.

8. Method according to one of the preceding claims, wherein the substrate (21) presents a decoration.
